Europäisches Patentamt

(19) European Patent Office (11) Publication number: **0 036 499**

Office européen des brevets **B1**

(12) **EUROPEAN PATENT SPECIFICATION**

(45) Date of publication of patent specification: **15.08.84**
(51) Int. Cl.³: **H 01 L 21/00, H 01 L 21/285, H 01 L 21/60, H 01 L 21/76, H 01 L 29/72**

(21) Application number: **81101364.8**

(22) Date of filing: **25.02.81**

(54) A polysilicon-base self-aligned bipolar transistor process.

(30) Priority: **24.03.80 US 133155**

(43) Date of publication of application:
**30.09.81 Bulletin 81/39**

(45) Publication of the grant of the patent:
**15.08.84 Bulletin 84/33**

(84) Designated Contracting States:
**DE FR GB IT**

(73) Proprietor: **International Business Machines Corporation**
**Old Orchard Road**
**Armonk, N.Y. 10504 (US)**

(72) Inventor: **Ho, Allen Pang-I**
**2 High Point Drive**
**Poughkeepsie New York 12603 (US)**
Inventor: **Horng, Cheng Tzong**
**6396 Gondola Way**
**San Jose California 95120 (US)**

(74) Representative: **Rudolph, Wolfgang**
**Schönaicher Strasse 220**
**D-7030 Böblingen (DE)**

(56) References cited:
IBM TECHNICAL DISCLOSURE BULLETIN, vol. 22, no. 9, February 1980, NEW YORK (US) T.H. YEH: "Self-aligned integrated NPN (vertical) and PNP (lateral) structures", pages 4047-4051
IBM TECHNICAL DISCLOSURE BULLETIN, vol. 21, no. 2, July 1978, NEW YORK (US) T.H. NING et al.: "Bipolar transistor structure", pages 846-849
IBM TECHNICAL DISCLOSURE BULLETIN, vol. 22, no. 8A, January 1980, NEW YORK (US) R.D. ISAAC et al.: "Method for fabricating a self-aligned vertical PNP transistor", pages 3393-3396

(58) References cited:
IBM TECHNICAL DISCLOSURE BULLETIN, vol. 21, no. 12, May 1979, NEW YORK (US) I.T. HO et al.: "Stacking polysilicon devices for high density LSI", pages 4843-4844
IBM TECHNICAL DISCLOSURE BULLETIN, vol. 22, no. 8B, January 1980, NEW YORK (US) I. ANTIPOV: "Undercut contacts for poly Si Base", pages 3693-3694

Courier Press, Leamington Spa, England.

## Description

The present invention relates to processes for the fabrication of very small integrated bipolar transistors, in which doped polysilicon is used for the base contact, and in which a self-aligned contact to the emitter is realized.

Numerous integrated circuit devices, structures and techniques of fabricating same, are known to the prior art. The following prior art patents and summaries are submitted to generally represent the state of the art.

Reference is made to U.S. Patent No. 3,852,127 entitled "Method of Manufacturing Double Diffused Transistor with Base Region Parts of Different Depths" granted December 3, 1974 to J. S. Lamming. The Lamming patent discloses a method of manufacturing a transistor by double diffusion. First one type impurities having a slow diffusion rate to form the emitter region are diffused. Then opposite type impurities having a high diffusion rate to form the base are diffused so that some traverse the emitter region, with the consequence that part of the base impurities are selectively retarded as they travel through the emitter region and penetrate to a lesser depth.

Reference is made to U.S. Patent No. 3,881,242 entitled "Method of Manufacturing Semiconductor Devices" granted May 6, 1975 to R. Nuttall et al. The Nuttall et al patent discloses a method of providing an ohmic contact for a silicon semiconductor device. The ohmic contact including a layer of tungsten or molybdenum on a polycrystalline silicon layer, includes depositing these two layers consecutively in the same deposition apparatus, the polycrystalline layer being deposited from a silane atmosphere at 700 to 750°C and the metal layer being deposited when a vapour of a compound of the metal, such as the hexafluoride, is supplied to modify the deposition atmosphere, the compound being reduced by the silane.

Reference is made to U.S. Patent No. 3,904,450, entitled "Method of Fabricating Injection Logic Integrated Circuits Using Oxide Isolation" granted September 9, 1975 to W. J. Evans et al. The Evans et al patent discloses an integrated injection logic circuit cell structure and its fabrication. A pattern of oxide isolation regions is used to define, at least partially, the introduction of two types of impurities in such a way as to reduce the number of masking steps. Certain of these oxide regions do not penetrate through the conventional epitaxial layer, leaving a lateral buried path to serve as the base of a lateral injection transistor. A pattern of polycrystalline silicon containing impurities is used both as a diffusion source and an interconnection.

Reference is made to U.S. Patent No. 4,006,046 entitled "Method for Compensating for Emitter-Push Effect in the Fabrication of Transistors" granted February 1, 1977 to P. C. Pravin. The Pravin patent discloses a semiconductor wafer having a base dopant source disposed on its surface which receives a surface coating consisting of, for example, a silicon nitride film. An emitter opening is formed in the silicon nitride surface coating and a portion of the base dopant source is stripped away within the emitter opening. Diffusion of the base region will result in predetermined geometrical regions of varying concentration of the base dopant as a result of the surface coating and the effect of the oxidizing atmosphere. Subsequent deposition and diffusion of the emitter region provides for smaller base widths and eliminates the need for subsequent deposition and diffusion of high concentration base dopant contact regions.

Reference is made to U.S. Patent No. 4,007,474 entitled "Transistor Having an Emitter with a Low Impurity Concentration Portion and A High Impurity Concentration Portion" granted February 18, 1977 to H. Yagi et al. The Yagi et al patent discloses a semiconductor device having a high current amplification gain which includes a low impurity concentration in the emitter region of the device, an injected minority carrier diffusion length L greater than the width of the emitter, and a high impurity concentration region of the same type as the emitter overlying at least a portion of said emitter region which provides a built-in-field where there is a drift current of minority carriers back toward the base region. The built-in field is larger than $kT(qL)$ so that the drift current adjacent the built-in-field substantially cancels the minority carrier diffusion current injected from the base region.

Reference is made to U.S. Patent No. 4,080,619 entitled "Bipolar Type Semiconductor Device" granted March 21, 1978 to K. Suzuki. The Suzuki patent discloses a bipolar-type semiconductor device, such as a bipolar transistor, having a heavily doped emitter region, a lightly doped emitter region, a base region, a collector region and a passivation layer or layers on said regions. The passivation layer formed on a surface end of a PN junction between the collector region and the base region is a polycrystalline silicon containing oxygen atoms in a range between 14 and 35 atomic percents. The other passivation layer formed on a surface end of the other PN junction between the base region and the lightly doped emitter region is made of silicon dioxide, which covers also a surface end of lightly doped and heavily doped (LH) junction between two emitter regions.

Reference is made to U.S. Patent No. 4,157,269 entitled "Utilizing Polysilicon Diffusion Sources and Special Masking Techniques" granted June 5, 1979 to T. H. Ning et al. The T. H. Ning et al patent discloses a method consisting of a sequence of process steps for fabricating a bipolar transistor having base contacts formed of a polysilicon material an emitter contact formed of a polysilicon material or metal. The emitter contact is self-aligned to the base contacts by the use of process steps wherein a single mask aperture is used for defining the base contacts and the emitter.

Reference is made to U.S. Patent No. 4,160,991 entitled "High Performance Bipolar Device and Method for Making Same" granted July 10, 1979 to N. G. Anantha et al. The Anantha et al patent discloses a method for manufacturing a high performance bipolar device and the resulting structure which has a very small emitter-base spacing. The small emitter-base spacing reduces the base resistance compared to earlier device spacing and thereby improves the performance of the bipolar device. The method involves providing a silicon semiconductor body having regions of monocrystalline silicon isolated from one another by isolation regions and a buried subcollector therein. A base region is formed in the isolated monocrystalline silicon. A mask is formed on the surface of the silicon body covering those regions designated to be the emitter and collector reach through regions. A doped polycrystalline silicon layer is then formed through the mask covering the base region and making ohmic contact thereto. An insulating layer is formed ovec the polysilicon layer. The mask is removed from those regions designated to be the emitter and collector reach through regions. The emitter junction is then formed in the base region and the collector reach through formed to contact the buried subcollector. Electrical contacts are made to the emitter and collector. The doped polycrystalline silicon layer is the electrical contact to the base regions.

Reference is made to the following IBM Technical Disclosure Bulletin Publications: (1) "Method For Reducing The Emitter-Base Contact Distance in Bipolar Transistors" by C. G. Jambotkar, Vol. 19, No. 12, May 1977, pages 4601—4; and (2) "Stacking Poly-Silicon Devices For High Density LSI" by I. T. Ho and J. Riseman, Vol. 21, No. 12, May 1979, pages 48434.

Reference is made to the publication entitled "A New Polysilicon Process For A Bipolar Device—PSA Technology", by Kenji Okada et al., IEEE Transactions on Electron Devices, Vol. Ed-26, No. 4, April 1979, pages 385—389.

Reference is made to IBM TDB, Vol. 22, No. 9, February 1980, pages 4047—4051, from which document is known a process for fabricating a bipolar transistor in a silicon substrate of a first conductivity type, said substrate having a planar surface, a subcollector region of a second conductivity type formed in said substrate, an epitaxial layer of said second conductivity type formed on said planar surface of said substrate, first and second spaced apart recessed oxide isolation regions extending through said epitaxial layer and said subcollector region into said substrate and a third spaced apart recessed oxide isolation region extending through said epitaxial layer into said subcollector region, said process including the following steps in the order recited:

a) chemically vapor depositing a layer of polycrystalline silicon on the exposed surface of said substrate, said polysilicon layer being doped with impurities of said first conductivity type said polysilicon layer having a thickness of approximately 300 nm;

b) chemically vapor depositing a first silicon dioxide layer having a thickness of approximately 300 nm;

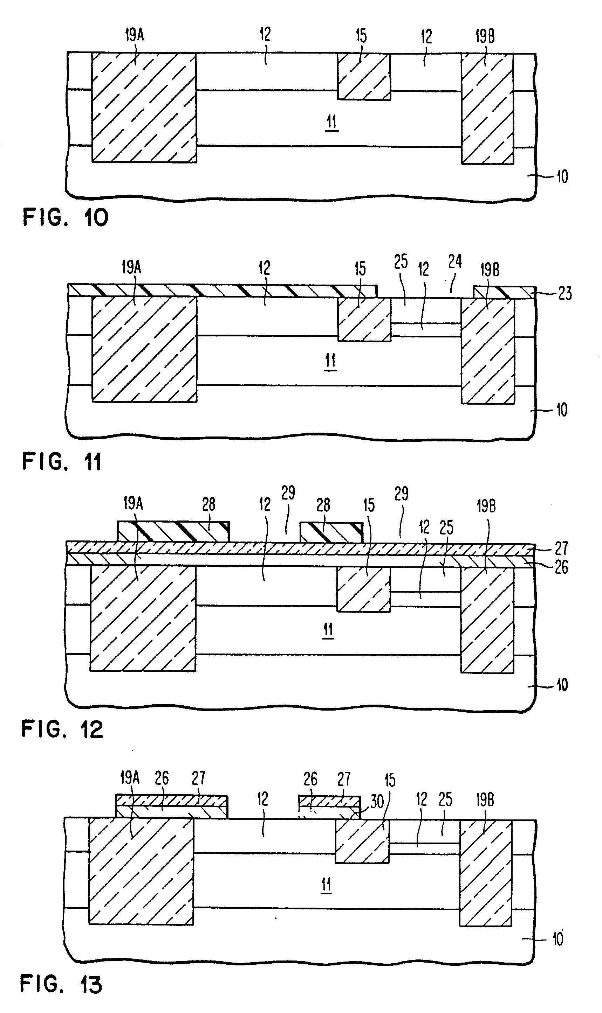

c) utilizing photolithography on the exposed surface of the first silicon dioxide layer to provide a second mask (28, Figure 12) having first and second windows said first window exposing a portion of said silicon dioxide layer spaced between said first and third spaced apart recessed oxide regions, said second window exposing a portion of said layer over said collector reach-through region;

d) utilizing reactive ion etch techniques to remove portions of said first silicon dioxide layer and the underlying portions of said polysilicon layer exposed by said windows of the second mask;

e) thermally growing a thin screen oxide on the exposed surface of the substrate within said first and second windows of the second mask said thin screen oxide having a thickness of approximately 30 nm;

f) utilizing photolithography provide a first mask (23, Figure 11) having a window extending from said second recessed oxide isolation region to said third recessed oxide isolation region;

g) ion implanting ions of said second conductivity type into the portion of said epitaxial layer exposed by the window in the first mask to provide a collector reach-through region;

h) removing the first mask and providing a third mask having a window extending from said first to said third recessed oxide isolation region;

i) ion implanting ions of said first conductivity type to form an intrinsic base region and removing said third mask;

j) chemically vapor depositing a second oxide layer on the exposed surface of the substrate and on the surface of the first silicon dioxide layer, said second oxide layer having a thickness of approximately 300 nm;

k) utilizing reactive ion etching to remove said second oxide layer except for the sidewall portions of the layer, these sidewall portions defining an emitter opening;

l) providing a fourth mask having a window extending from said first to said third recessed oxide isolation region and ion implanting ions of said second conductivity type to provide an emitter region;

m) performing a thermal cycle to anneal and activate the implanted collector reach-through region, the active base region and the emitter region, also simultaneously the first conductivity type polysilicon will outdiffuse impurities to form the extrinsic base region.

The present trend in semiconductor technology is toward large scale integration of devices with very high speed and very low power dissipation. It is furthermore the object of the invention claimed to provide a self-aligned emitter to polysilicon base process for fabrication a bipolar transistor structure which allows that the devices be made as small as possible by making the vertical junction structure shallower, and reducing the horizontal geometry and which removes the misregistration problem encountered in the process in accordance with the prior art.

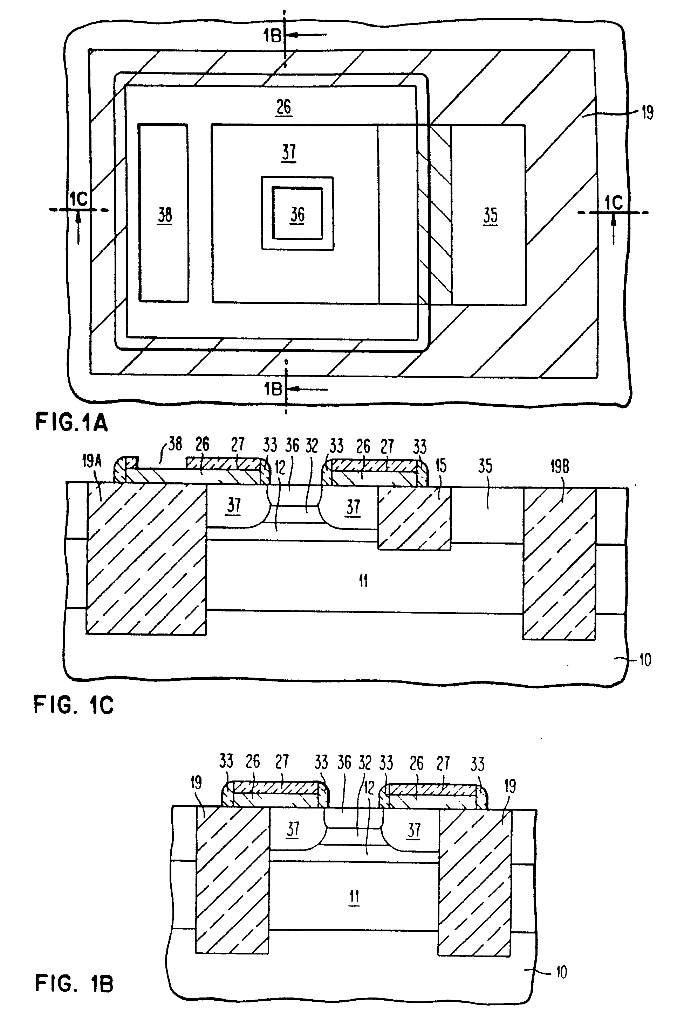

The transistor structure formed by the process according to this invention is shown in Figs. 1A, 1B and 1C. A deep trench dielectric isolation is used to isolate the device from other devices on the wafer. A shallow dielectric isolation is used to separate the collector reach-through region from the base region. A heavily doped polysilicon layer is used to dope and make contact to the transistor base region, as well as define the emitter window through which the emitter is doped. The polysilicon is covered on both top and side by a layer of silicon dioxide which is deposited by chemical vapor deposition. Contact to the polysilicon, and hence to the transistor base, is done over the deep trench dielectric isolation, thus allowing the transistor base area, and hence the collector-base capacitance, to be minimized.

In accordance with the invention and in contrast to other self-aligned processes where the intrinsic base and emitter are implanted through the same opening, the process allows the intrinsic base to be implanted first with the polysilicon as a mask. This decreases the intrinsic base resistance without affecting the emitter-base breakdown or leakage.

The process, in accordance with the invention, is inherently simple and gives well-defined vertical polysilicon sidewalls with controllable chemically vapor deposited (CVD) oxide barriers. This is very important in defining very small devices.

The process includes a single heat cycle to drive in the emitter and base. No extended heat cycles are needed to grow thick thermal oxides.

The invention will become more apparent from the following detail description taken in conjunction with accompanying drawings.

Figure 1A is a top view of a transistor structure produced by the process in accordance with the invention.

Figure 1B is a cross-sectional view taken along the line 1B—1B of Figure 1A.

Figure 1C is a cross-sectional view taken along the line 1C—1C of Figure 1A.

Figures 2 through 17 are cross-sectional views disclosing the structure at successive stages, or steps in accordance with the invention.

Description of the preferred embodiments

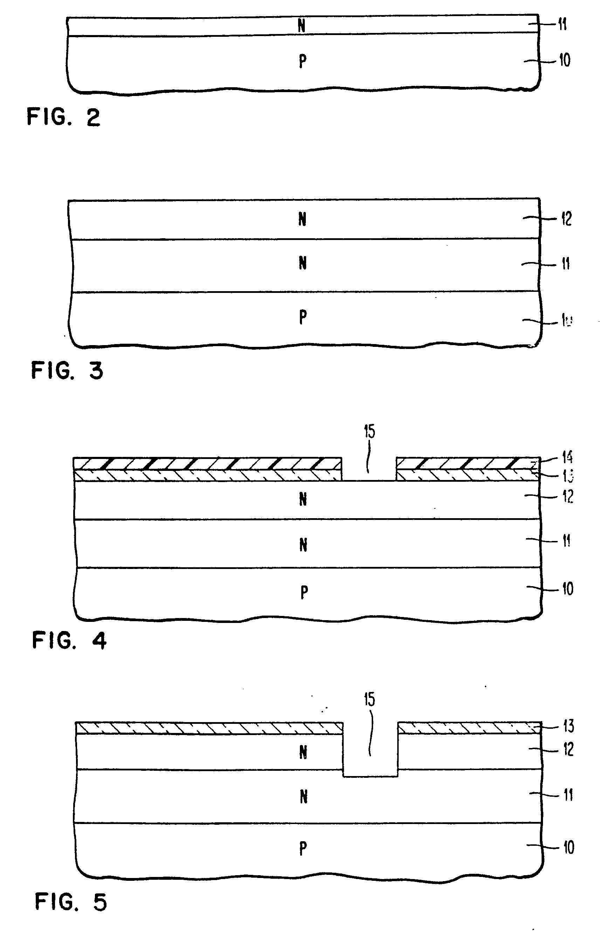

Referring now to the figures of the drawings and Figure 2 in particular, a P-type monocrystalline silicon wafer 10 is the starting substrate. An N-type impurity is then introduced into substrate 10 forming the subcollector 11. The impurity can be any suitable N-type impurity, as for example, arsenic, and can be introduced into the wafer by any suitable technique, as for example, capsule diffusion or ion implantation. The resistivity of the N-subcollector layer 11 is approximately 0.001 ohm/cm$^2$. As shown in Figure 3, an N-type epitaxial silicon layer 12 of approximately 1.0 micrometer to 1.5 micrometer thickness is deposited on the exposed surface. During the epitaxial deposition process, which is a high temperature process, the subcollector region 11 diffuses upward into the region 12. The resistivity of the epitaxial layer is about 0.3 ohm/cm$^2$. As shown in Figure 4, an oxide layer 13 preferably deposited by using chemical vapor deposition techniques, of approximately 300 nm thickness is deposited on layer 12. A resist layer 14 is deposited over oxide layer 13 and subsequently exposed and developed to form an opening 15 which overlies the position of the shallow dielectric isolation trench to be fabricated. The resist layer 14 serves as a mask for a reactive-ion etching oxide operation. The etching is stopped when it reaches the surface of epitaxial silicon 12. The resist layer 14 is then stripped.

Referring to Figure 5, using the oxide layer 13 as an etch mask, the exposed silicon in region 15 is then etched by a reactive-ion etching technique. The etching will be stopped when it reaches to the N+ subcollector region 11. The remaining oxide mask layer 13 is stripped by a chemical solution, for example, buffer-HF solution.

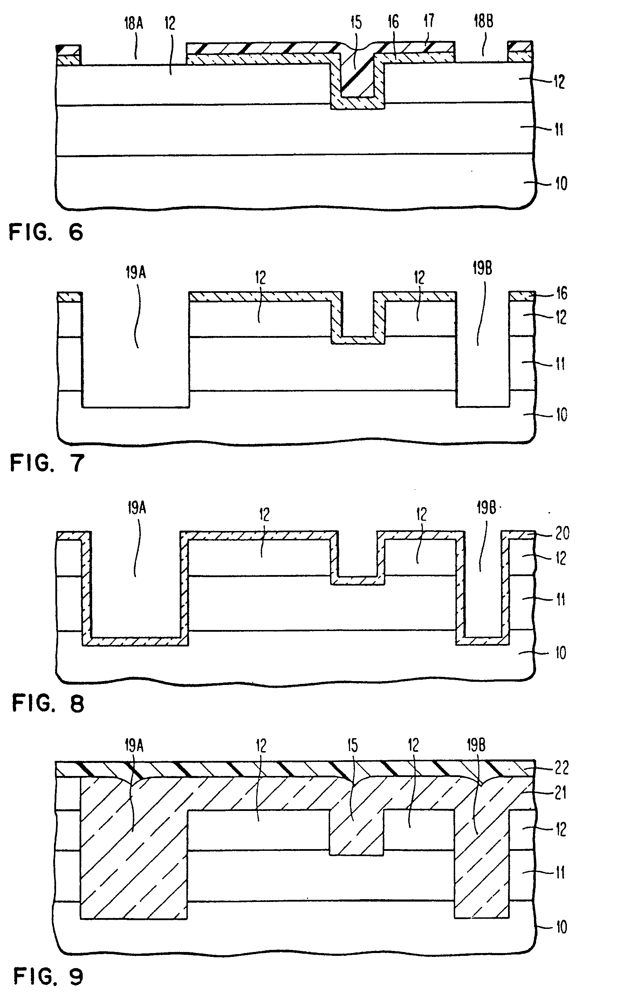

Referring to Figure 6, a CVD oxide layer 16, approximately 600—700 nm thick, is then deposited on the wafer. A resist layer 17 is deposited and subsequently exposed and developed to form window 18A—18B which overlies the position of the deep dielectric isolation trench to be fabricated. The resist layer 17 serves as a mask for the reactive-ion etching of oxide layer 16. The etching is stopped when the silicon layer 12 is reached. The resist layer is then stripped. Using the oxide layer 16 as shown in Figure 7, as an etch mask, the exposed silicon in window region 18A—18B is reactive-ion etched.

As shown in Figure 7, the reactive ion etching of silicon is stopped when it etches through epitaxial layer 12, subcollector layer 11 and reaches into the P substrate 10 to form deep trench 19. The depth of the deep trench 19A—19B is approximately 4—5 micrometer. The remaining masking oxide 16 is then stripped.

As shown in Figure 8, the wafer is thermally oxidized to form an oxide layer 20 over the exposed silicon surface. The thickness of the thermal oxide grown is about 100—200 nm.

Referring to Figure 9, a thick oxide layer 21 formed by CVD technique is used to fill the shallow trench 15 and deep trench 19A—19B and also planarize the wafer surface. For a 3 micrometer wide deep trench the oxide thickness required to overfill the trench is about 3 micrometers. As shown in Figure 9, crevices in the center area of the overfilled trenches may be formed. In this case a blanket resist layer 22 may be applied and appropriately treated to planarize the surface 21. The subsequent process step is the use of reactive ion etching to thin back the resist layer 22 and the oxide layer 21. Of primary importance is that the reactive ion etch rate of the resist 22 is nearly equal to that of $SiO_2$. Thus, with an equal thickness of resist and $SiO_2$ everywhere over the wafer, a back-etching to the silicon will yield a planar surface with filled in deep trench 19A—19B and shallow trench 15 as shown in Figure 10.

As demonstrated in Figure 11, a resist layer 23 is deposited on the wafer surface. The resist layer 23 is exposed and developed to form the first mask with a block-out window 24 which overlies the intended transistor reach-through region. A suitable N-type impurity preferably phosphorus, is ion implanted into the epitaxial layer 12 to form reach-through region 25. The resist layer 23 is then stripped.

As shown in Figure 12, a layer of polycrystalline silicon 26 of approximately 300 nm thickness is deposited by chemical vapor deposition onto the epitaxial surface 12. The polycrystalline silicon can be either in-situ doped with boron during the deposition step, or alternatively it can be doped after the deposition step by an ion implantation with boron. In either case its boron concentration should be high, of the order of $10^{20}$ atoms per cubic centimeter. Next, a first layer of silicon dioxide 27 of approximately 300 nm thickness is deposited by chemical vapor deposition. Subsequently, a photoresist layer 28 is deposited on the wafer. The resist layer is then exposed and developed to form the second mask with first and second windows 29 where the oxide and polysilicon will be removed. The oxide 27 is then removed by a reactive ion etch, using the resist layer as a mask. The etch used should etch silicon dioxide much faster than resist. The resist 28 is then stripped off. Next the polysilicon 26 is etched using the first oxide 27 as a mask, with a reactive ion etch which etches silicon much faster than oxide. The device at this point is shown in Figure 13. The polysilicon etch-stop point can be monitored at the polysilicon-oxide interface 30.

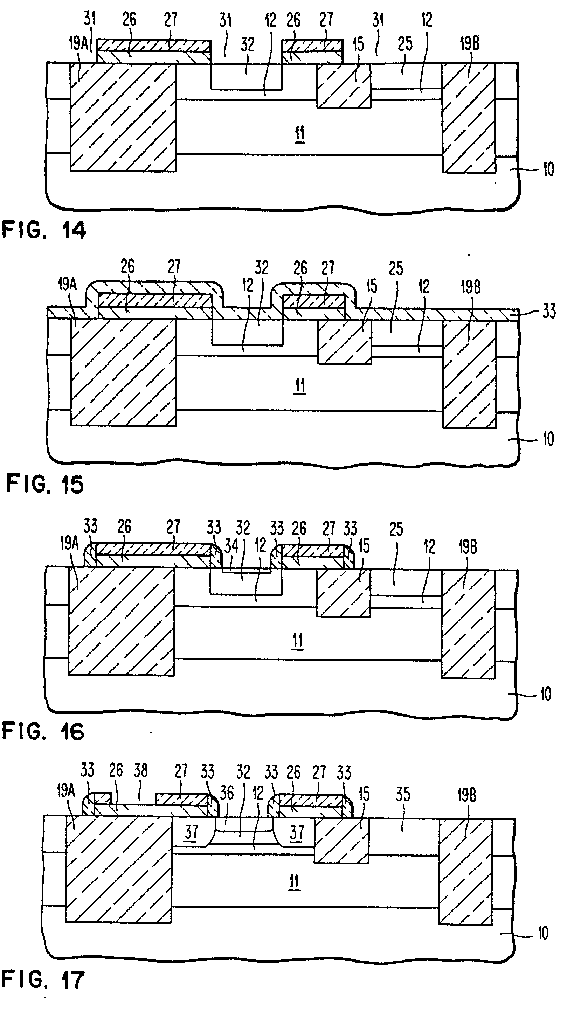

As shown in Figure 14, a thin thermal screen oxide 31 of approximately 30 nm thickness is grown on all exposed silicon surfaces. Next a low dose boron ion implantation is done to form the active base region 32. The boron implant is allowed to penetrate the reach-through region 25 also, where it will be compensated by the much higher phosphorus dose.

As shown in Figure 15, a second layer of silicon dioxide 33 of approximately 300 nm thickness is deposited by chemical vapor deposition. Since such an oxide layer is highly conformal, the oxide on the sides as well as the top of the polysilicon and first oxide layer (26 and 27) will be approximately 300 nm thick. The second oxide layer 33 is then etched away using a reactive ion etch for which the etch rate of oxide is much faster than the etch rate of silicon. The device at this point is shown in Figure 16. Since the reactive ion etch is highly directional, the 300 nm thick second oxide 33 on the sides of the polysilicon will remain. Next, a low-energy arsenic ion implant 34 is done to form the emitter. The arsenic implant also enters the reach-through 25 to reduce the contact resistance there. The arsenic implant is shielded from the polysilicon 26 by the first oxide layer 27.

As shown in Figure 17, a thermal cycle is done to anneal and activate the implanted reach-through 35, active base 32, and emitter 36. Simultaneously, the boron in the heavily-doped polysilicon 26 will outdiffuse to form the extrinsic base 37. Next, a base contact 38 to the polysilicon is opened by photolithography and etching. The device is now ready for deposition and fabrication of the metallurgy which will interconnect the device with other devices on the wafer. The forming of the metallurgy system is well known in the art and will not be described.

**Claim**

1. Process for fabricating a bipolar transistor in a silicon substrate (10) of a first conductivity type, said substrate (10) having a planar surface, a subcollector region (11) of a second conductivity type formed in said substrate, an epitaxial layer (12) of said second conductivity type formed on said planar surface of said substrate, first and second spaced apart recessed oxide isolation regions (19A, 19B) extending through said epitaxial layer and said subcollector region into said substrate (and a third spaced apart recessed oxide isolation region (15) extending through said epitaxial layer into said subcollector region), said process including the following steps in the order recited:

a) utilizing photolithography on the exposed surface of said substrate to provide a first mask (23, Figure 11) having a window (24) extending from said second recessed oxide isolation region (19B) to said third recessed oxide isolation region (15);

b) ion implanting ions of said second conductivity type into the portion of said epitaxial layer exposed by the window (24) in the first mask (23) to provide a collector reach-through region (25, Figure 11);

c) removing the first mask (23);

d) chemically vapor depositing a layer (26, Figure 12) of polycrystalline silicon on the exposed surface of said substrate, said polysilicon layer being doped with impurities of said first conductivity type said polysilicon layer (26) having a thickness of approximately 300 nm and an impurity concentration in the order of $10^{20}$ atoms per cubic centimeter;

e) chemically vapor depositing a first silicon dioxide layer (27) having a thickness of approximately 300 nm;

f) utilizing photolithography on the exposed surface of the first silicon dioxide layer (27) to provide a mask (28, Figure 12) having first and second windows (29), said first window exposing a portion of said silicon dioxide layer (27) spaced between said first (19A) and third (15) spaced apart recessed oxide regions, said second window exposing a portion of said second silicon dioxide layer (27) over said collector reach-through region (25);

g) utilizing reactive ion etch techniques to remove portions of said first silicon dioxide layer (27) and the underlying portions of said polysilicon layer (26) exposed by said windows (29) of the second mask (28, Figure 13);

h) thermally growing a thin screen oxide (31, Figure 14) on the exposed surface of the substrate within said first and second windows of the second mask said thin screen oxide (31) having a thickness of approximately 30 nm;

i) ion implanting said exposed surface of the substrate within said first and second windows of the second mask (28) with ions of said first conductivity type to form an intrinsic base region (32, Figure 14);

j) chemically vapor depositing a second oxide layer (33, Figure 15) on the exposed surface of the substrate and on the surface of the first silicon dioxide layer (27), said second oxide layer (33) having a thickness of approximately 300 nm;

k) utilizing reactive ion etching to remove said second oxide layer (33) except for the sidewall portions of this layer (33, Figure 16), these sidewall portions defining an emitter opening;

l) ion implanting said exposed surface of the substrate with ions of said second conductivity type to provide an emitter region (36, Figure 17) within the intrinsic base region and to reduce the contact resistance of the reach-through region (35);

m) performing a thermal cycle to anneal and activate the implemented collector reach-through region (35), the active base region (32) and the emitter region (36), also simultaneously the first conductivity type polysilicon (26, Figure 17) will outdiffuse impurities to form the extrinsic base region (37).

**Patentanspruch**

1. Verfahren zur Herstellung eines bipolaren Transistors in einem Siliciumsubstrat (10) eines ersten Leitfähigkeitstyps, wobei das Substrats (10) eine planare Oberfläche hat, einen Subkollektorbereich (11) eines zweiten Leitfähigkeitstyps in diesem Substrat, eine Epitaxieschicht (12) des zweiten Leitfähigkeitstyps auf der planaren Oberfläche des Substrats, erste und zweite beabstandete, in einer Vertiefung vorgesehene Oxidisolationsbereiche (19A), (19B), die sich durch die Epitaxieschicht und den Subkollektorbereich in das Substrat erstrecken (sowie einen dritten beabstandeten, in einer Vertiefung vorgesehenen Isolationsbereich (15), der sich durch die Epitaxieschicht in den Subkollektorbereich erstreckt), wobei dieses Verfahren die folgenden Schritte in der unten angegebenen Reihenfolge umfaßt:

a) Anwenden der Photolithographie auf der belichteten Oberfläche des Substrats zur Herstellung einer ersten Maske (23, Fig. 11) mit einem Fenster (24) von dem zweiten, in einer Vertiefung angebrachten Oxidisolationsbereich (19B) zum dritten, in einer Vertiefung angebrachten Oxidisolationsbereich (15);

b) Implantation von Ionen des zweiten Leitfähigkeitstyps in den Teil der Epitaxieschicht, der durch das Fenster (24) in der ersten Maske (23) belichtet wird, um einen Kollektor-Durchgriffsbereich (25, Fig. 11) vorzusehen;

c) Entfernen der ersten Maske (23);

d) Aufdampfen einer Schicht (26, Fig. 12) aus polykristallinem Silicium auf der belichteten Oberfläche des Substrats, wobei diese Polysiliciumschicht mit Störstellen des ersten Leitfähigkeitstyps dotiert ist, und wobei diese Polysiliciumschicht (26) eine Stärke von ungefähr 100 nm und eine Störstellenkonzentration in der Größenordnung von $10^{20}$ Atomen/cm³ aufweist;

e) Aufdampfen einer ersten Siliciumdioxidschicht (27) mit einer Dicke von ungefähr 300 nm;

f) Anwenden der Photolithographie auf der belichteten Oberfläche der ersten Siliciumdioxidschicht (27), um eine Maske (28, Fig. 12) vorzusehen mit ersten und zweiten Fenstern (29), wobei das erste Fenster einen Teil der Siliciumdioxidschicht (27) zwischen den ersten (19A) und dritten (15) beabstandeten, in einer Vertiefung vorgesehenen Oxidbereichen belichtet, und wobei das zweite Fenster einen Teil der zweiten Siliciumdioxidschicht (27) über dem Kollektor-Durchgriffsbereich (25) belichtet;

g) Anwenden von reaktivem Ionenätzen zur Ent-

fernung von Teilen der ersten Siliciumdioxidschicht (27) und von darunterliegenden Teilen der Polysiliciumschicht (26), die durch die Fenster (29) der zweiten Maske (28, Fig. 13) belichtet werden;

h) thermisches Aufwachsen eines dünnen Oxidfilms (31, Fig. 14) auf der belichteten Oberfläche des Substrats innerhalb den ersten und zweiten Fenstern der zweiten Maske, wobei der dünne Oxidfilm (31) eine Dicke von ca. 30 nm aufweist;

i) Implantierung der belichteten Substratoberfläche innerhalb der ersten und zweiten Fenster der zweiten Maske (28) mit Ionen des ersten Leitfähigkeitstyps zur Bildung eines intrinsischen Basisbereichs (32, Fig. 14);

j) Aufdampfen einer zweiten Oxidschicht (33, Fig.15) auf der belichteten Substratoberfläche und auf der Oberfläche der ersten Siliciumdioxidschicht (27), wobei die zweite Oxidschicht (33) eine Dicke von ungefähr 300 nm aufweist;

k) Anwendung des reaktiven Ionenätzens zur Entfernung der zweiten Oxidschicht (33), mit Ausnahme der Seitenteile dieser Schicht (33, Fig. 16), die eine Emitteröffnung beschreiben;

l) Implantieren der belichteten Substratoberfläche mit Ionen des zweiten Leitfähigkeitstypes, um einen Emitterbereich (36, Fig. 17) innerhalb des intrinsischen Basisbereichs vorzusehen, und dem den Kontaktwiderstand des Durchgriffbereichs (35) zu reduzieren

m) Ausführung eines Thermalzyklus, um den implantierten Kollektor-Durchgriffsbereich (35) zu härten und zu aktivieren sowie den aktiven Basisbereich (32) und den Emitterbereich (36), wobei gleichzeitig die Polysiliciumschicht (26, Fig. 17) des ersten Leitfähigkeitstyps Störstellen zur Bildung des extrinsischen Basisbereichs (37) ausdiffundiert.

**Revendication**

1. Procédé pour fabriquer un transistor bipolaire dans un substrat en silicium (10) possédant un premier type de conductivité, ledit substrat (10) comportant une surface planar, une région (11) située au-dessous du collecteur et possédant un second type de conductivité et formée dans ledit substrat, une couche épitaxiale (12) possédant ledit second type de conductivité et formée sur ladite surface planar dudit substrat, des première et seconde régions isolantes d'oxyde distances et en renfoncement (19A, 19B) s'étendant à travers ladite couche épitaxiale et ladite région située au-dessus du collecteur pour pénétrer dans ledit substrat (et une troisième région isolante d'oxyde distante et en renfoncement (15) s'étendant à travers ladite couche épitaxiale pour pénétrer dans ladite région située au-dessous du collecteur), ledit procédé incluant les phases opératoires suivantes dans l'ordre cité:

a) Utilisation de la photolithographie de la surface à nu dudit substrat pour réaliser un premier masque (23, Figure 11) possédant une fenêtre (24) s'étendant depuis ladite seconde région d'oxyde en renfoncement (19B) jusqu'à ladite troisième région isolante d'oxyde en renfoncement (15);

b) Implantation d'ions possédant ledit second type de conductivité à l'intérieur de la partie de ladite couche épitaxiale, mise à nu par la fenêtre (24) dans le premier masque (24) de manière à réaliser une région de pénétration du collecteur (25, Figure 11);

c) Elimination du premier masque (23);

d) Dépôt chimique en phase vapeur d'une couche (26, Figure 12) de silicium polycristallin sur la surface à nu dudit substrat, ladite couche de polysilicium étant dopée avec des impuretés possédant ledit premier type de conductivité et ladite couche de polysilicium (26) possédant une épaisseur d'environ 300 nm et une concentration en impuretés de l'ordre de $10^{20}$ atomes par centimètre cube;

e) Dépôt chimique en phase vapeur d'une première couche de bioxyde de silicium (27) possédant une épaisseur d'environ 300 nm;

f) Utilisation de la photolithographie sur la surface à nu de la première couche de bioxyde de silicium (27) de manière à réaliser un masque (28, Figure 12), possédant des première et seconde fenêtres (29), ladite première fenêtre mettant à nu une partie de ladite couche de bioxyde de silicium (27) distante située entre lesdites première (19A) et troisième (15) régions d'oxyde distantes et en renfoncement, ladite seconde fenêtre mettant à nu une partie de ladite seconde couche de bioxyde de silicium (27) au-dessus de ladite région (25) de perçage du collecteur;

g) Utilisation de techniques de corrosion ionionique réactive pour éliminer les parties de ladite première couche de bioxyde de silicium (27) et des parties sous-jacentes de ladite couche de polysilicium (26), mises à nu par lesdites fenêtres (29) du second masque (28, Figure 13);

h) Croissance thermique d'un oxyde de protection mince (31, Figure 4) sur la surface à nu du substrat à l'intérieur desdites première et seconde fenêtres du second masque, ledit oxyde de protection mince (31) possédant une épaisseur d'environ 30 nm;

i) Implantation d'ions dans ladite surface à nu du substrat à l'intérieur desdites première et seconde fenêtre du second masque (28), au moyen d'ions possédant ledit premier type de conductivité de manière à former une région de base (32, Figure 14);

j) Dépôt chimique en phase vapeur d'une seconde couche d'oxyde (33, Figure 15) sur la surface à nu du substrat et sur la surface de la première couche de bioxyde de silicium (27), ladite seconde couche d'oxyde (33) possédant une épaisseur d'environ 300 nm;

k) Utilisation d'une corrosion ionique réactive pour éliminer ladite seconde couche d'oxyde (33) hormis au niveau des parois latérales de cette couche (33, Figure 16), ces parois latérales définissant une ouverture d'émetteur;

l) Implantion d'ions dans ladite surface à nu du substrat à l'aide d'ions possédant ledit second type de conductivité de manièrè à former une région d'émetteur (36, Figure 17) à l'intérieur de la région de base intrinsèque et pour réduire la résistance de contact de la région de pénétration (35).

m) Mise en oeuvre d'un cycle thermique pour recuire et activer la région implantée de pénétration du collecteur (35), la région de base active (32) et la région d'émetteur (36), tout en réalisant également simultanément une diffusion d'impuretés hors du polysilicium possédant le premier type de conductivité (26, Figure 17) de manière à former la région de base extrinsèque (37).

FIG.1A

FIG. 1C

FIG. 1B

FIG. 2

FIG. 3

FIG. 4

FIG. 5

FIG. 6

FIG. 7

FIG. 8

FIG. 9

FIG. 10

FIG. 11

FIG. 12

FIG. 13

**FIG. 14**

**FIG. 15**

**FIG. 16**

**FIG. 17**